# EUROPÄISCHE PATENTANMELDUNG

(11) **EP 1 466 998 A1**
(43) Veröffentlichungstag der Anmeldung: **13.10.2004**
(21) Anmeldenummer: 04007889.1
(22) Anmeldetag: 01.04.2004
(51) Int. Cl.: C23C 14/24, C23C 14/26, C30B 23/00

(54) **Effusionszelle mit verbesserter Temperaturkontrolle des Tiegels**

(30) Priorität: 09.04.2003 DE 10316228
(71) Anmelder: Dr. Eberl MBE-Komponenten GmbH, 71263 Weil der Stadt (DE)
(72) Erfinder: Schuler, Heiko, 71120 Grafenau (DE); Eberl, Karl, 12435 Berlin (DE); Huber, Frank, 71263 Weil der Stadt (DE)

(57) **Zusammenfassung**

Die Temperaturankopplung des Tiegels (4) einer Effusionszelle an ein den Tiegel (4) umgebendes, als heizbares Kühlreservoir dienendes Aufnahmeteil (1) wird dadurch verbessert, indem in den Zwischenraum (2) zwischen dem Tiegel (4) und der Wand einer Ausnehmung (1A) des Aufnahmeteils (1) ein Übertragungsmedium mit hoher Wärmeleitfähigkeit und niedrigem Dampfdruck (bsp. Ga, In, Hg oder weicher Feststoff) eingebracht wird. Durch die verbesserte thermische Ankopplung des Tiegels (4) folgt die Temperatur des Tiegels (4) schneller der des heizbaren Kühlreservoirs, so dass Materialien mit hohem Dampfdruck mit relativ niedrigen Verdampfungstemperaturen kontrollierter abgeschieden werden können.

## Beschreibung

Die vorliegende Erfindung betrifft eine Effusionszelle für Aufdampfverfahren und eine Verwendung dieser Effusionszelle für ein Aufdampfverfahren, insbesondere zum Aufdampfen von organischen Materialien oder Materialien mit vergleichbar hohem Dampfdruck.

Die Erfindung bezieht sich somit auf das Gebiet der Herstellung dünner Schichten durch Aufdampfen eines gewünschten Materials auf ein Substrat unter Vakuum- bis Ultrahochvakuum-Bedingungen. Derartige Aufdampfprozesse werden vor allem in der Halbleitertechnik aber auch bei anderen Materialien mit der Molekularstrahl-Epitaxie durchgeführt. In den entsprechenden Verdampfungseinrichtungen werden sogenannte Effusionszellen zur Erzeugung eines Molekularstrahles des gewünschten Materials verwendet. In diesen wird ein Tiegel, in dem sich die zu verdampfende Substanz befindet, auf eine bestimmte Temperatur geheizt und der verdampfende Materialstrom tritt durch eine relativ schmale Öffnung im Ultrahochvakuum aus der Zelle aus und kann als Molekular- oder Atomstrahl auf die zu beschichtende Oberfläche gerichtet werden.

Für eine kontrollierte Abscheidung ist eine relativ genaue Kontrolle der Temperatur des Tiegels von großer Bedeutung. Deshalb sind Effusionszellen meistens mit einer Temperaturregelung versehen, bei der die Temperatur des Tiegels durch ein Thermoelement erfasst und Temperaturschwankungen in ein Regelsignal zur Regelung eines Heizstroms umgesetzt werden. Für die zumeist gebräuchlichen, relativ hohen Betriebstemperaturen von Effusionszellen von mehreren hundert bis über tausend Grad Celsius, liefert die allgemein übliche Methode des Wärmestrahlungsheizens und der Wärmestrahlungskühlung des Tiegels ausreichend stabile Betriebsbedingungen.

Es ist jedoch bisher sehr schwierig, Materialien mit hohem Dampfdruck, die bereits bei Raumtemperatur oder bis ca. 200°C verdampfen oder sublimieren (z.B. organische Materialien) sehr kontrolliert abzuscheiden, da der Wärmeübergang zwischen dem Tiegel und dem heizbaren Kühlreservoir im Allgemeinen hauptsächlich über den Austausch von Wärmestrahlung erfolgt und daher bei niedrigen Temperaturen die Temperatur des Tiegels der Temperatur des Reservoirs nur sehr langsam folgt und sich daher nur sehr langsam stabile Temperaturverhältnisse im Tiegel einstellen.

Es ist gleichwohl wünschenswert, diese Materialien aus einem Tiegel oder anderen inerten Behälter durch exakte Temperaturkontrolle thermisch zu verdampfen, um somit auch für diese Materialien ein kontrolliertes Schichtwachstum zu ermöglichen. Es ist allerdings schwierig, derartige Tiegel, insbesondere wenn diese aus Quarzglas oder Keramik bestehen, im Vakuum großflächig an ein Heiz- und Kühlreservoir anzukoppeln. Durch die schlechte Ankopplung des Tiegels ist die Tiegelabkühlzeit im Vakuum sehr lange, so dass eine exakte, 0,1°C genaue Temperaturregelung äußerst schwierig ist. Eine weitere Schwierigkeit ergibt sich für die Temperaturmessung selbst, da der Temperatursensor nicht einfach fest mit dem Tiegel verbunden werden kann.

Es ist somit Aufgabe der vorliegenden Erfindung, eine Effusionszelle mit verbesserter Temperaturkontrolle anzugeben, mit der auch Aufdampfverfahren im niederen Temperaturbereich für Materialien mit hohem Dampfdruck durchgeführt werden können.

Diese Aufgabe wird durch die Merkmale des auf eine Effusionszelle gerichteten Patentanspruchs 1 und des auf ein Aufdampfverfahren gerichteten Patentanspruchs 11 gelöst. Vorteilhafte Weiterbildungen und Ausgestaltungen sind Gegenstand von Unteransprüchen.

Ein wesentlicher Gedanke der vorliegenden Erfindung besteht darin, in einer Effusionszelle den Zwischenraum zwischen dem Tiegel und einem als heizbares Kühlreservoir dienenden Aufnahmeteil mit einem Gas, einer Flüssigkeit oder einem plastisch verformbaren Festkörpermaterial als Übertragungsmedium zu füllen. Das Übertragungsmedium ersetzt den bei niedrigen Temperaturen uneffektiven Wärmetransport durch Wärmestrahlung durch den bei tiefen Temperaturen effektiveren Wärmetransport durch Wärmeleitung und sorgt dafür, dass der Tiegel ohne große Verzögerungszeiten die von dem heizbaren Kühlreservoir eingestellte Temperatur annimmt.

Das heizbare Kühlreservoir ist dabei eine Vorrichtung in der zum Zweck der besseren Regelbarkeit und rascheren Reaktion auf gewünschte Temperaturänderungen gleichzeitig geheizt und gegengekühlt werden kann, um schliesslich eine Temperatur zwischen Heizertemperatur und Temperatur des Kühlmediums am Tiegel einzustellen. Zusätzlich kann durch ausschliessliches Heizen eine vergleichsweise hohe Tiegeltemperatur oder durch ausschliessliches Kühlen eine niedrige Tiegeltemperatur eingestellt werden.
Mit dem heizbaren Kühlreservoir kann der Tiegel beispielsweise auch auf eine Temperatur in der Nähe oder unterhalb der Raumtemperatur eingestellt und mittels eines Temperaturfühlers und einer Regelung kann die eingestellte Temperatur exakt geregelt werden.

Das Aufnahmeteil ist beispielsweise ein Materialblock, der vorzugsweise eine hohe Wärmeleitfähigkeit besitzt und eine Ausnehmung für die Aufnahme des Tiegels enthält. Das Aufnahmeteil kann beispielsweise aus einem Metall oder einer Keramik hergestellt sein. Es kann selbst als Kühlreservoir ausgebildet sein, beispielsweise indem Kühlleitungen darin eingebettet sind, die mit Wasser oder einem Kältemedium geflutet werden. Das Aufnahmeteil kann aber auch lediglich an ein entsprechend gestaltetes primäres Kühlreservoir thermisch angekoppelt sein, so dass in ihm selbst keine Kühlleitungen enthalten sind. In dem Aufnahmeteil kann dann eine Heizvorrichtung enthalten sein, die beispielsweise als ein Heizdraht ausgebildet ist, der in das Aufnahmeteil eingebettet ist. Weiterhin kann das Aufnahmeteil aber auch lediglich an eine entsprechend gestaltete Heizvorrichtung thermisch angekoppelt sein, sodass in ihm selbst kein Heizdraht enthalten ist. Mittels der Heizvorrichtung und des Kühlreservoirs kann die Temperatur des Aufnahmeteils innerhalb bestimmter Grenzen beliebig eingestellt werden, wobei ein in unmittelbarer Nähe zu dem Tiegel in das Aufnahmeteil eingebettetes Thermoelement und eine damit verbundene Temperaturregelung für die Einhaltung des gewünschten Temperaturwertes sorgen. Dieser Wert kann auch nahe bei Raumtemperatur oder auch darunter liegen, so dass auch eine kontrollierte Verdampfung von Materialien mit hohem Dampfdruck bei relativ niedrigen Temperaturen (z.B. organische Materialien) ermöglicht werden kann.

Die in dem Materialblock bzw. das Aufnahmeteil geformte Ausnehmung und/oder der Tiegel können im Prinzip beliebige Formen annehmen. Es sind jedoch in an sich bekannter Weise runde Gefäßformen von Vorteil, die im Querschnitt kreis- oder ellipsenförmig und im Längsschnitt parabelförmig sind. Die Ausnehmung und der Tiegel können so geformt und dimensioniert sein, dass sie einander im Wesentlichen kongruent sind, so dass ein Zwischenraum zwar nominell nicht vorgesehen ist, jedoch aufgrund von Ungenauigkeiten der Abmessungen der Bauteile, durch die Tiegelfixierung bedingte Veränderungen der relativen Lagen der Bauteile zueinander oder durch Rauigkeiten der Materialoberflächen praktisch stets vorhanden ist. Es kann aber auch ebenso vorgesehen sein, dass die Ausnehmung und der Tiegel so geformt und dimensioniert sind, dass sie einander nicht kongruent sind, so dass absichtlich ein Zwischenraum zwischen beiden gebildet wird, um beispielsweise zu einem räumlich homogenen Wärmeübergang zwischen dem Aufnahmeteil und dem Tiegel beizutragen. Dieser Zwischenraum kann sich beispielsweise von einem Bodenbereich ausgehend entlang der Wand des Tiegels zylindersymmetrisch zur Zylinderachse des Tiegels und der Ausnehmung bis zu einer vorgegebenen Höhe erstrecken. Dabei kann sich der Zwischenraum auch bis zum oberen Rand der Ausnehmung erstrecken.

Der Zwischenraum kann offen oder allseitig geschlossen sein. Das in dem Zwischenraum enthaltene Übertragungsmedium kann aufgrund seines niedrigen Dampfdrucks und/oder aufgrund des dichten Verschlusses des Zwischenraums nicht daraus entweichen. Die Abdichtung kann bereits dadurch gewährleistet sein, dass der Tiegel in an sich üblicher Weise einen umlaufenden Kragen aufweist, welcher auf einem Randabschnitt der Ausnehmung des Aufnahmeteils aufliegt. Durch die Fixierung des Kragens an dem Randabschnitt kann der Zwischenraum gewünschtenfalls hermetisch abgeschlossen werden.

Das in den Zwischenraum eingefüllte Wärmeübertragungsmedium weist also vorzugsweise niedrigen Dampfdruck und gute Wärmeleitfähigkeit auf, damit der Tiegel an die beheizte und gekühlte Umgebung in optimaler Weise thermisch angekoppelt ist. Dies kann ein hierfür geeignetes Gas, eine Flüssigkeit oder aber auch ein weiches Festkörpermaterial sein. Es kommen beispielsweise Gallium, Indium, Quecksilber und Legierungen damit, hochsiedende Öle, Silikonöle und -fette, Metallgewebe, Metallwolle oder andere Materialien infrage, die mit den vorgenannten Materialien insofern vergleichbar sind, als sie einen größenordnungsmäßig vergleichbaren oder geringeren Dampfdruck unter Vakuum- bis Ultrahochvakuum-Bedingungen aufweisen. Die Wahl derartiger Materialien ist insofern vorteilhaft, als der Zwischenraum dann im Betrieb nicht hermetisch abgeschlossen sein muss. Je dichter der Zwischenraum abgeschlossen ist, umso geringer sind die Anforderungen hinsichtlich des Dampfdrucks des Übertragungsmediums.

In der Zeichnungsfigur ist ein einziges Ausführungsbeispiel für eine erfindungsgemäße Effusionszelle dargestellt.

Ein Materialblock 1, der aus einem Material mit guter Wärmeleitfähigkeit wie beispielsweise Metall oder einer geeigneten Keramik hergestellt ist, weist eine runde Ausnehmung 1A auf, in die ein Tiegel 4 eingesetzt ist. In dem Längsschnitt ist zu erkennen, dass die Ausnehmung und der Tiegel Rundgefäße sind, d.h. dass sowohl die Wand der Ausnehmung 1A als auch die Wand des Tiegels 4 parabelförmig sind, wobei der Tiegel 4 einen etwas geringeren Durchmesser und eine etwas geringere Tiefe als die Ausnehmung 1A aufweist, so dass zwischen der Wand des Tiegels 4 und der Wand der Ausnehmung 1A ein Zwischenraum 2 gebildet ist.

In dem Tiegel 4 befindet sich die zu verdampfende Substanz 7, die im Ausgangszustand eine feste oder flüssige Substanz sein kann.

Der Materialblock 1 ist thermisch an ein Kühlreservoir 9 angekoppelt, so dass er sich ohne Erwärmung auf einer relativ niedrigen, durch das Wasser- oder Kältemittel-gekühlte Kühlreservoir 9 bestimmten Temperatur befindet. In dem Materialblock 1 ist eine Heizvorrichtung z.B. in Form eines spiralförmigen Heizdrahtes 3, z.B. aus Tantal, eingebettet, durch den die Temperatur des Materialblocks 1 eingestellt werden kann. Mit einem Thermoelement 6, welches in dem Materialblock 1 eingebettet ist und sich relativ nahe an dem Tiegel 4 befindet, kann die Temperatur des Materialblocks 1 gemessen und einer Temperaturregelung zugeführt werden.

Der Tiegel 4 weist einen oberen Kragen 4A auf und liegt mit diesem auf einem oberen Randabschnitt der Ausnehmung 1A auf. Eine Tiegelfixierung 5 sorgt dafür, dass der Kragen 4A fest mit dem Materialblock 1 verbunden wird, so dass der Zwischenraum 2 mehr oder weniger dicht abgeschlossen wird, wobei gegebenenfalls ein Dichtmedium wie ein Dichtring (nicht dargestellt) zwischen dem Kragen 4A und dem Randabschnitt an geeigneter Stelle eingesetzt werden kann. Der Zwischenraum 2 kann gewünschtenfalls auch durch die Tiegelfixierung 5 hermetisch dicht abgeschlossen sein.

Der Zwischenraum 2 ist ganz oder auch teilweise mit einem Wärmeübertragungsmedium gefüllt. Dieses sollte eine hohe Wärmeleitfähigkeit und einen niedrigen Dampfdruck aufweisen, so dass keinerlei Entweichen des Übertragungsmediums in die evakuierte Umgebung erfolgen kann. Im dargestellten Ausführungsbeispiel erstreckt sich der Zwischenraum 2 ausgehend von einem Bodenbereich des Tiegels 4 und der Ausnehmung 1A zylindersymmetrisch entlang der Wand des Tiegels 4 und der Wand der Ausnehmung 1A bis zum oberen Rand der Ausnehmung 1A. Alternativ dazu kann ebenso vorgesehen sein, dass der Zwischenraum 2 sich nur bis zu einer bestimmten Höhe des Tiegels 4 erstreckt und dass von dieser Höhe an die Wand des Tiegels 4 unmittelbar mit der Wand der Ausnehmung 1A verbunden ist.

Es ist ferner ein einschwenkbarer oder klappbarer Verschluss 8 vorgesehen, durch den der Tiegel 4 im Vakuum dicht verschließbar ist.

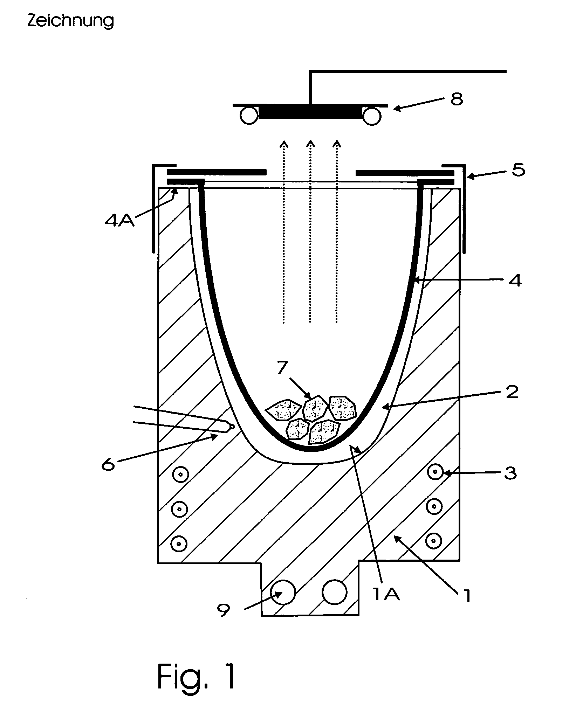

## Patentansprüche

1. Effusionszelle für Aufdampfverfahren, mit
- einem Tiegel (4) für eine zu verdampfende Substanz (7),
- einem als heizbares Kühlreservoir ausgebildeten Aufnahmeteil (1) mit einer Ausnehmung (1A) für die Aufnahme des Tiegels (4), wobei
- ein Zwischenraum (2) zwischen der Ausnehmung (1A) und dem Tiegel (4) mindestens teilweise mit einem Gas, einer Flüssigkeit oder einem plastisch verformbaren Festkörper als Wärmeübertragungsmedium gefüllt ist.

2. Effusionszelle nach Anspruch 1,
**dadurch gekennzeichnet, dass**
- das Aufnahmeteil (1) selbst als Kühlreservoir ausgebildet ist oder an ein primäres Kühlreservoir (9) thermisch angekoppelt ist, und
- in dem Aufnahmeteil (1) eine Heizvorrichtung (3) enthalten ist oder das Aufnahmeteil (1) an eine Heizvorrichtung thermisch angekoppelt ist.

3. Effusionszelle nach Anspruch 2,
**dadurch gekennzeichnet, dass**
- die Heizvorrichtung (3) als Heizdraht (3) ausgebildet ist, der in das Aufnahmeteil (1) eingebettet ist und insbesondere spiralförmig um die Ausnehmung (1A) verläuft.

4. Effusionszelle nach einem der vorhergehenden Ansprüche,
**dadurch gekennzeichnet, dass**
- das Aufnahmeteil (1) als Materialblock (1) ausgebildet ist.

5. Effusionszelle nach einem der vorhergehenden Ansprüche,
**dadurch gekennzeichnet, dass**
- das Aufnahmeteil (1) aus Metall oder Keramik hergestellt ist.

6. Effusionszelle nach einem der vorhergehenden Ansprüche,
**dadurch gekennzeichnet, dass**
- die Ausnehmung (1A) und der Tiegel (4) zueinander im Wesentlichen kongruent geformt sind.

7. Effusionszelle nach einem der vorhergehenden Ansprüche,
**dadurch gekennzeichnet, dass**
- die Ausnehmung (1A) und der Tiegel (4) zueinander im Wesentlichen nicht kongruent geformt sind.

8. Effusionszelle nach einem der vorhergehenden Ansprüche,
**dadurch gekennzeichnet, dass**
- der Tiegel (4) einen umlaufenden Kragen (4A) aufweist, welcher auf einem Randabschnitt der Ausnehmung (1A) aufliegt.

9. Effusionszelle nach einem der vorhergehenden Ansprüche,
**dadurch gekennzeichnet, dass**
- der Zwischenraum (2) Ga, In oder Hg enthält oder mit einer Substanz gefüllt ist, die einen mit Ga, In oder Hg größenordnungsmäßig vergleichbaren oder geringeren Dampfdruck unter Vakuum- bis Ultrahochvakuum-Bedingungen aufweist.

10. Effusionszelle nach einem der vorhergehenden Ansprüche,
**dadurch gekennzeichnet, dass**
- in dem Aufnahmeteil (1) ein Temperatursensor (6), insbesondere ein Thermoelement (6), eingebettet ist.

11. Aufdampfverfahren mit einer Effusionszelle, welche
- einen Tiegel (4) für die Aufnahme einer zu verdampfenden Substanz (7), und
- einen als heizbares Kühlreservoir ausgebildeten Aufnahmeteil (1), insbesondere einen Materialblock (1), mit einer Ausnehmung (1A) für die Aufnahme des Tiegels (4) aufweist, wobei
- ein Zwischenraum zwischen dem Aufnahmeteil (1) und dem Tiegel (4) mindestens teilweise mit einem Gas, einer Flüssigkeit oder einem plastisch verformbaren Festkörper als Wärmeübertragungsmedium gefüllt wird.

12. Verfahren nach Anspruch 11, bei welchem der Zwischenraum (2) Ga, In oder Hg enthält oder mit einer Substanz gefüllt wird, die einen mit Ga, In oder Hg größenordnungsmäßig vergleichbaren oder geringeren Dampfdruck unter Vakuum- bis Ultrahochvakuum-Bedingungen aufweist.
